# EUROPÄISCHE PATENTSCHRIFT

(11) **EP 1 504 015 B1**
(45) Veröffentlichungstag und Bekanntmachung des Hinweises auf die Patenterteilung: **25.04.2007**
(21) Anmeldenummer: 03717225.1
(22) Anmeldetag: 24.03.2003
(51) Int. Cl.: C07F 15/00

(54) **RHODIUM- UND IRIDIUM-KOMPLEXE**
RHODIUM AND IRIDIUM COMPLEXES
COMPLEXES DE RHODIUM ET D'IRIDIUM

(30) Priorität: 05.04.2002 DE 10215010
(43) Veröffentlichungstag der Anmeldung: 09.02.2005
(73) Patentinhaber: Merck Patent GmbH, 64293 Darmstadt (DE)
(72) Erfinder: STÖSSEL, Philipp, 65929 Frankfurt (DE); BACH, Ingrid, 65812 Bad Soden (DE); SPREITZER, Hubert, 68519 Viernheim (DE); BECKER, Heinrich, 61479 Glashütten (DE)
(74) Vertreter: Benz, Jürgen
(86) Internationale Anmeldenummer: PCT/EP2003/003023
(87) Internationale Veröffentlichungsnummer: WO 2003/084972

(56) Entgegenhaltungen:
- EP-A- 1 138 746
- EP-A- 1 175 128
- EP-A- 1 191 613
- WO-A-02/02714

## Beschreibung

Metallorganische Verbindungen - speziell Verbindungen der d⁸-Metalle - werden in naher Zukunft als Wirkkomponenten (= Funktionsmaterialien) in einer Reihe von verschiedenartigen Anwendungen, die im weitesten Sinne der Elektronikindustrie zugerechnet werden können, Einsatz als funktionelle Komponenten finden.

Bei den auf organischen Komponenten basierenden Organischen-Elektrolumineszenz-Vorrichtungen (allg. Beschreibung des Aufbaus vgl.

US-A-4,539,507 und US-A-5,151,629) bzw. deren Einzelbauteilen, den Organischen-Lichtemittierenden-Dioden (OLEDs) ist die Markteinführung bereits erfolgt, wie die erhältlichen Auto-Radios mit "Organischem Display" der Firma Pioneer belegen. Weitere derartige Produkte stehen kurz vor der Einführung. Trotz allem sind hier noch deutliche Verbesserungen nötig, um diese Displays zu einer echten Konkurrenz zu den derzeit marktbeherrschenden Flüssigkristallanzeigen (LCD) zu machen bzw. diese zu überflügeln.

Eine Entwicklung hierzu, die sich in den letzten beiden Jahren abzeichnet, ist der Einsatz von metallorganischen Komplexen, die Phosphoreszenz statt Fluoreszenz zeigen [M. A. Baldo, S. Lamansky, P. E. Burrows, M. E. Thompson, S. R. Forrest, Applied Physics Letters, **1999**, *75*, 4-6].

Aus theoretischen Spin-statistischen Gründen ist unter Verwendung metallorganischer Verbindungen als Phosphoreszenz-Emittern eine bis zu vierfache Energie- und Leistungseffizienz möglich. Ob sich diese neue Entwicklung durchsetzen wird, hängt stark davon ab, ob entsprechende Device-Kompositionen gefunden werden können, die diese Vorteile (Triplett-Emission = Phosphoreszenz gegenüber Singulett-Emission = Fluoreszenz) auch in den OLEDs umsetzen können. Als wesentliche Bedingungen für praktische Anwendung sind hier insbesondere eine hohe operative Lebensdauer, eine hohe Stabilität gegenüber Temperaturbelastung und eine niedrige Einsatz- und Betriebsspannung, um mobile Applikationen zu ermöglichen, zu nennen.

Daneben muß der effiziente chemische Zugang zu den entsprechenden Organo-Metall-Verbindungen gegeben sein. Von besonderem Interesse sind dabei Organo-Rhodium- und Iridium-Verbindungen. Bei diesen ist vor allem unter Berücksichtigung des Rhodium- bzw. des Iridiumpreises von maßgebender Bedeutung, dass ein effizienter Zugang zu entsprechenden Derivaten ermöglicht wird.

Aus EP-A-1191613 sind Phenylpyridin-Komplexe und elektrisch leitende Bauteile enthaltend solchen Komplex bekannt. In der Literatur wurden bis jetzt zwei Bautypen von OLEDs, die Phosphoreszenzemitter als farbgebende Komponenten aufweisen, beschrieben.

Der erste Typ (Typ 1) hat typischerweise den folgenden Schicht-Aufbau [M. E. Thompson et. al., Proceedings of SPIE, 31.07 - 02.08.2000, San Diego, USA, Volume 4105, Seite 119 - 124]:
1. Trägerplatte = Substrat (üblicherweise Glas oder Kunststoffolien).
2. Transparente Anode (üblicherweise Indium-Zinn-Oxid, ITO).
3. Lochtransport-Schicht: üblicherweise auf Basis von Triarylamin-Derivaten.
4. Elektronentransport- und Emissions-Schicht: diese Schicht besteht aus einem Elektronentransportmaterial, das mit dem Phosphoreszenzemitter dotiert ist.
5. Elektronentransport-Schicht: größtenteils auf Basis von Aluminium-tris-8-hydroxy-chinoxalinat (AIQ₃).
6. Kathode: hier werden in der Regel Metalle, Metallkombinationen oder Metalllegierungen mit niedriger Austrittsfunktion verwendet so z. B. AI-Li.

Der zweite Typ (Typ 2) hat typischerweise den folgenden Schicht-Aufbau [T. Tsutsui et al. Jpn. J. Appl. Phys., **1999**, *38*, L 1502 - L 1504]:
1. Trägerplatte = Substrat (üblicherweise Glas oder Kunststoffolien).
2. Transparente Anode (üblicherweise Indium-Zinn-Oxid, ITO).
3. Lochtransport-Schicht: üblicherweise auf Basis von Triarylamin-Derivaten.
4. Matrix- und Emissions-Schicht: diese Schicht besteht aus einem Matrixmaterial üblicherweise auf Basis von Triarylamin-Derivaten, das mit dem Phosphoreszenzemitter dotiert ist.
5. Elektronentransport-/Lochblockier-Schicht: üblicherweise auf Basis von Stickstoff-Heterocyclen.
7. Kathode: hier werden in der Regel Metalle, Metallkombinationen oder Metalllegierungen mit niedriger Austrittsfunktion verwendet, so z. B. Al.

Es ist auch möglich das Licht aus einer dünnen transparenten Kathode auszukoppeln. Diese Vorrichtungen werden entsprechend (je nach Anwendung) strukturiert, kontaktiert und schließlich auch hermetisch eingesiegelt, da sich i. d. R. die Lebensdauer derartiger Vorrichtungen bei Anwesenheit von Wasser und/oder Sauerstoff drastisch verringert.

Die Kenndaten der oben beschriebenen OLED's zeigen zwei Schwachpunkte auf: Zum einen, sind die bisher beschriebenen Phosphoreszenzemitter auf der Basis von tris-orthometallierten Iridium-Komplexen zum Bau von effizienten blauen und insbesondere von tief blauen OLED's nicht geeignet, da keiner der bekannten Phosphoreszenzemitter im tief blauen, d.h. bei einer Emissionswellenlänge λₘₐₓ von kleiner als 465 nm emittiert.
Tief blaue Phosphoreszensemitter sind jedoch insbesondere zur Herstellung von Vollfarbdisplays, für welche die Grundfarben ROT-GRÜN-BLAU verfügbar sein müssen, von entscheidender Bedeutung.

Zum anderen, geht aus den Effizienz - Helligkeits - Kurven hervor, dass die Effizienz mit steigender Helligkeit stark abnimmt. Dies bedeutet, dass die in der Praxis notwendigen großen Helligkeiten nur über eine hohe Leistungsaufnahme erreicht werden können. Große Leistungsaufnahmen setzen aber große Batterieleistungen portabler Geräte (Mobile-Phones, Lap-Tops etc.) voraus. Außerdem kann die große Leistungsaufnahme, die zum großen Teil in Wärme umgesetzt wird, zur thermischen Schädigung des Displays führen.

Aus diesen Mängeln im Stand der Technik ergeben sich die folgenden Aufgaben. Zum einen besteht Bedarf zur Erzeugung von z. B. blauen - insbesondere tiefblauen - Triplett-Emittern gegeben, zum anderen müssen Triplett-Emitter bereitgestellt werden, die auch bei großen Helligkeiten möglichst lineare Effizienz - Helligkeits - Kurven aufweisen.

5'-Mono-, 5',5"-Di- und 5',5",5'''-Tris-cyano-funktionalisierte tris-orthometallierte Organo-Rhodium- und Organo-Iridium-Verbindungen - gemäß Verbindungen (I/Ia), (II/IIa), (III/IIIa) oder (IV/IVa) -, die Gegenstand der vorliegenden Erfindung sind, werden zentrale Schlüsselbausteine zur Erzeugung hocheffizienter Triplett-Emitter sein. Über eine entsprechende Cyano-Funktionalisierung können entscheidende Materialeigenschaften wie die Wellenlänge der Phosphoreszenzemission, d.h. die Farbe, die Phosphoreszenzquantenausbeute und die Redox- und Temperaturstabilität der Emitter, um nur einige Eigenschaften beispielhaft zu nennen, eingestellt werden.

Die Klasse der 5'-Mono-, 5',5"-Di- und 5',5",5'''-Tris-cyano-funktionalisierten tris-orthometallierten Organo-Rhodium- und Organo-Iridium-Verbindungen - gemäß Verbindungen (I/Ia), (II/IIa), (III/IIIa) oder (IV/IVa)- ist neu und bisher in der Literatur nicht beschrieben worden, ihre effiziente Darstellung und Verfügbarkeit als Reinstoffe ist aber für eine Reihe von elektro-optischen Anwendungen von großer Bedeutung.

Überraschend wurde nun gefunden, dass die Wellenlänge der Phosphoreszensemission eines Triplett-Emitters, d.h. die "Farbe" des emittierten Lichtes, bei Einführung Cyano-Funktionen in die 5'-, 5"- bzw. die 5"'-Position eine hypsochrome Verschiebung erfährt (s. Tabelle 1).

**Tabelle 1: Einfluß der 5-Substituenten auf Absorption und Phosphoreszens**

| **Referenz zu Beispiel 1** | **Beispiel 1** | **Referenz zu Beispiel 2** | **Beispiel 2** | **Referenz zu Beispiel 3** | **Beispiel 3** |
|---|---|---|---|---|---|
| 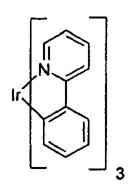 | 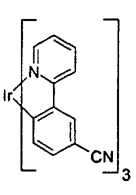 | 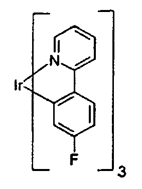 | 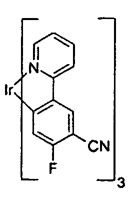 | 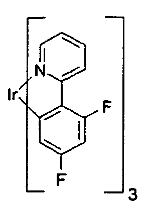 | 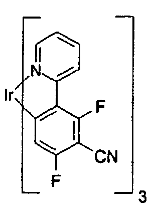 |
| λ_{max, Emission} | λ_{max, Emission} | λ_{max, Emission} | λ_{max, Emission} | λ_{max, Emission} | λ_{max, Emission} |
| **535 nm** | **515 nm** | **514 nm** | **464 nm** | **470 nm** | **452 nm** |
| **grün** | ***tief grün*** | **tief grün** | ***hellblau*** | **cyan** | ***tiefblau*** |

| | | | | | |
|---|---|---|---|---|---|
| λ_{max, Emission}: Maximum der Elektroluminiszenzbande | | | | | |

Neben dem direkten Einsatz von 5'-Mono-, 5',5"-Di- und 5',5",5"'-Tricyanofunktionalisierten tris-orthometallierten Organo-Rhodium- und Organo-Iridium-Verbindungen (gemäß Verbindungen (I/la), (II/IIa), (III/IIIa) oder (IV/IVa)), die Gegenstand der vorliegenden Erfindung sind, in Licht-emittierenden Vorrichtungen werden diese auch zentrale Schlüsselbausteine zur Erzeugung hocheffizienter Triplett-Emitter sein, da die Cyanofunktion mit Hilfe von gängigen, in der Literatur beschriebenen Methoden in eine Vielzahl von Funktionen umgewandelt werden kann. Ausgehend von den genannten Strukturen eröffnen literaturbekannte Methoden den Zugang zu Alkoholen, Aminen, Aldehyden und Carbonsäuren sowie deren Derivate aber auch zu Heterocyclen wie Azolen, Diazolen, Triazolen, Oxazolinen, Oxazolen, Oxadiazolen, Thiazolen, Thiodiazolen etc. sowie deren benzokondensierten Derivaten.

5'-Mono-, 5',5"-Di- und 5',5",5"'-Tri-cyano-tris-orthometallierte Organo-Rhodium- und Organo-Iridium-Verbindungen sowie Verfahren zu ihrer Herstellung sind neu und bisher in der Literatur nicht beschrieben worden. Diese gilt insbesondere für die Cyanierung halogenierter, aromatischer - *an das Metallzentrum gebundener-*Liganden, d. h. der Cyanierung am Metall-Komplexes durch den Austausch der Halogenfunktion durch die Cyanofunktion. Die effiziente Darstellung und Verfügbarkeit dieser Cyano-Verbindungen als Reinstoffe ist aber für verschiedene elektro-optische Anwendungen von großer Bedeutung.

Es wurde überraschend gefunden, dass die neuen Cyano-substituierten Organometallverbindungen (I/Ia), (II/IIa), (III/IIIa) oder (IV/IVa) - gemäß Schema 1 und 2 - ausgehend von den 5'-Mono-, 5',5"-Di- und 5',5",5'''-Tri-halogensubstituierten tris-orthometallierten Organo-Rhodium bzw. Organo-Iridium-Verbindungen (V) bzw. (VI) [Darstellung gemäß DE 10109027 A], d. h. ausgehend von *metallorganischen Arylhalogeniden -* durch stöchiometrische Umsetzung mit einem Übergangsmetallcyanid oder durch katalytische Umsetzung mit einem Übergangsmetallcyanid, gegebenenfalls in Anwesenheit eines Übergangsmetalls, einer Übergangsmetallverbindung und eines Phosphor-haltigen Additivs, sowie unter geeigneter Wahl der Reaktionsparameter wie Reaktionstemperatur, Reaktionsmedium, Konzentration und Reaktionszeiten reproduzierbar in etwa 90 - 98 % iger Ausbeute, ohne Verwendung chromatographischer Reinigungsverfahren, gegebenenfalls nach Umkristallisation, in Reinheiten von > 99 % nach NMR bzw. HPLC erhalten werden (siehe Beispiele 1-6).

Das oben beschriebene Verfahren zeichnet sich durch drei Eigenschaften besonders aus:

Erstens ist die selektive 5'-Mono-, 5',5"-Di- und 5',5",5"'-Tri-Cyanierung von koordinativ gebundenen Arylhalogeniden - d.h. von *metallorganischen Arylhalogeniden -* unerwartet und in dieser Form nicht bekannt.

Zweitens ist der hohe erzielte Umsatz, der sich in den reproduzierbar sehr guten Ausbeuten an isoliertem Produkt widerspiegelt, unerwartet und einzigartig für die Cyanierung von koordinativ gebundenen Arylhalogeniden.

Drittens fallen die erhaltenen Verbindungen ohne aufwendige chromatographische Reinigung, gegebenenfalls nach Umkristallisation, in sehr guten Reinheiten von > 99 % nach NMR bzw. HPLC an. Dies ist für die Verwendung in opto- > 99 % nach NMR bzw. HPLC an. Dies ist für die Verwendung in optoelektronischen Bauelementen, bzw. der Benutzung als Zwischenprodukte für die Darstellung entsprechender Verbindungen essentiell.

Wie oben geschildert, sind die erfindungsgemäßen Verbindungen nicht vorbeschrieben und damit neu.

Gegenstand der vorliegenden Erfindung sind somit die Verbindungen (I) und (II), gemäß Schema 1, 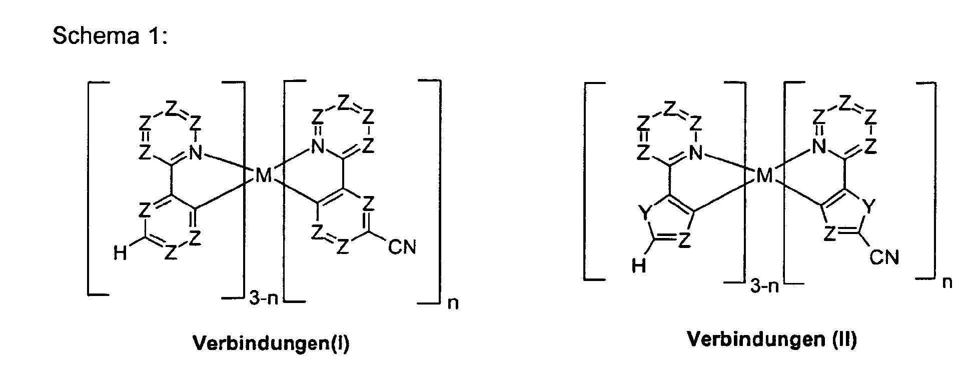 wobei die Symbole und Indizes folgende Bedeutung haben:
- M: Rh, Ir;
- Z: ist gleich oder verschieden bei jedem Auftreten N, CR ;
- Y: O, S, Se;
- R: ist gleich oder verschieden bei jedem Auftreten H, F, Cl, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR² - ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
- R¹,R²: sind gleich oder verschieden, H oder ein aliphatischer oder aromatischer Kohlenwasserstoffrest mit 1 bis 20 C-Atomen;
- n: ist 1, 2 oder 3

Eine weitere Ausführungsform der Erfindung sind solche Rh- bzw. Ir-komplexe, die gleichzeitig Liganden vom Typ wie bei Verbindungen (I) und solche von Verbindungen (II) aufweisen, d.h. gemischte Ligandensysteme. Diese werden durch die Formeln (la) und (IIa) - gemäß Schema 2 - beschrieben: 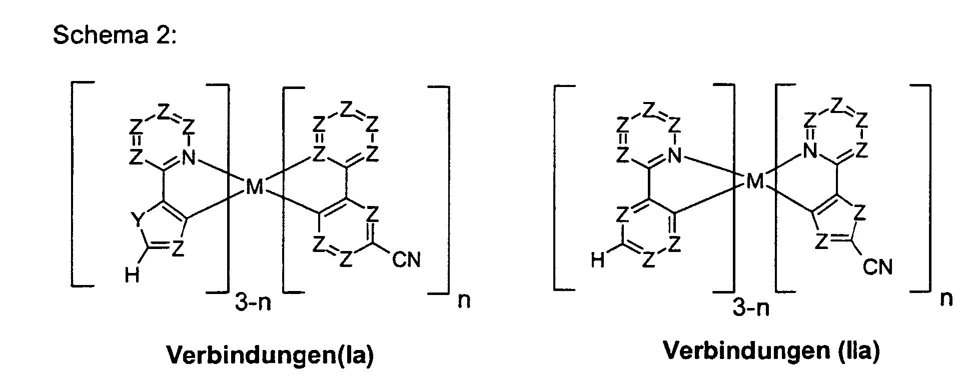 wobei die Symbole und Indizes die unter den Formeln (I) und (II) genannten Bedeutungen haben.

Bevorzugt sind erfindungsgemäße Verbindungen (I), (la), (II) und (IIa), bei denen für das Symbol Y = O, S gilt.

Ebenfalls bevorzugt sind erfindungsgemäße Verbindungen in denen der über das Stickstoffdonoratom ans Metall M gebundene Zyklus ein Pyrazin-, Pyridazin-, Pyrimidin- oder Triazin-Heterozyklus ist.

Besonders bevorzugt sind erfindungsgemäße Verbindungen der Formel (III), (IV) 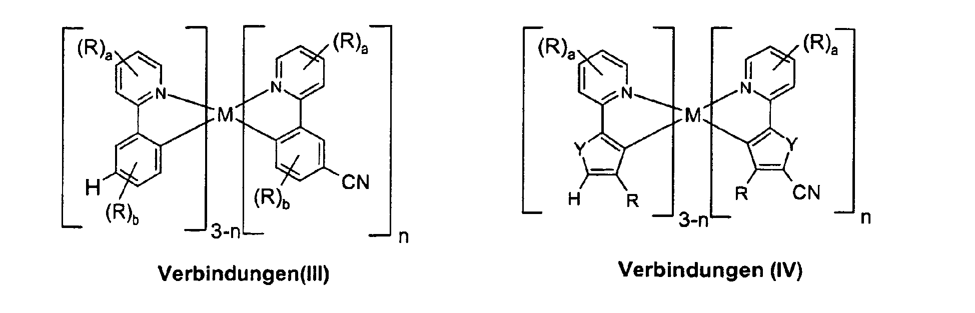 oder die weitere Ausführungsform der Erfindung, d.h. derartige Rhodium- und Iridium-Komplexe, die gleichzeitig Liganden vom Typ wie bei Verbindung (III) und solche von Verbindunge (IV) aufweisen, d.h. gemischte Ligandensysteme, wie in Formel (IIIa) und (IVa) beschrieben. 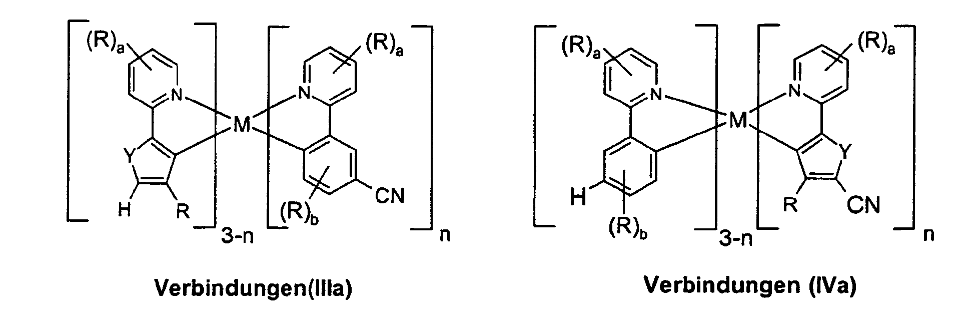 wobei die Symbole und Indizes die unter den Formeln (I) und (II) genannten Bedeutungen haben und
- a: ist 0, 1, 2, 3 oder 4, bevorzugt 0, 1 oder 2, besonders bevorzugt 0 oder 1;
- b: ist 0, 1, 2 oder 3, bevorzugt 0 oder 1.

Ein weiterer Gegenstand der vorliegenden Erfindung, ist ein Verfahren zur Herstellung der Verbindungen (I) bzw. (II), durch Umsetzung der Verbindungen (V) bzw. (VI), 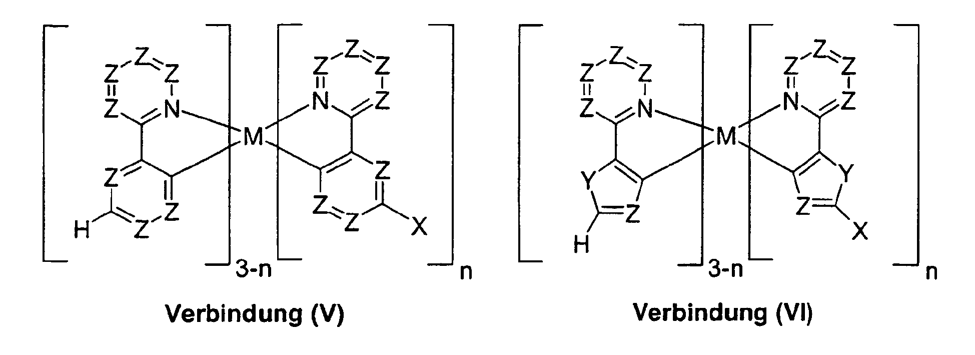 worin:
- X: Cl, Br oder I ist,
und M, Z, die Reste R und die Indizes a, und b und n die unter Verbindung (I) bzw. (II) genannten Bedeutungen haben, mit einem Cyanierungsagens.

Das erfindungsgemäße Verfahren wird durch Schema 2 erläutert:

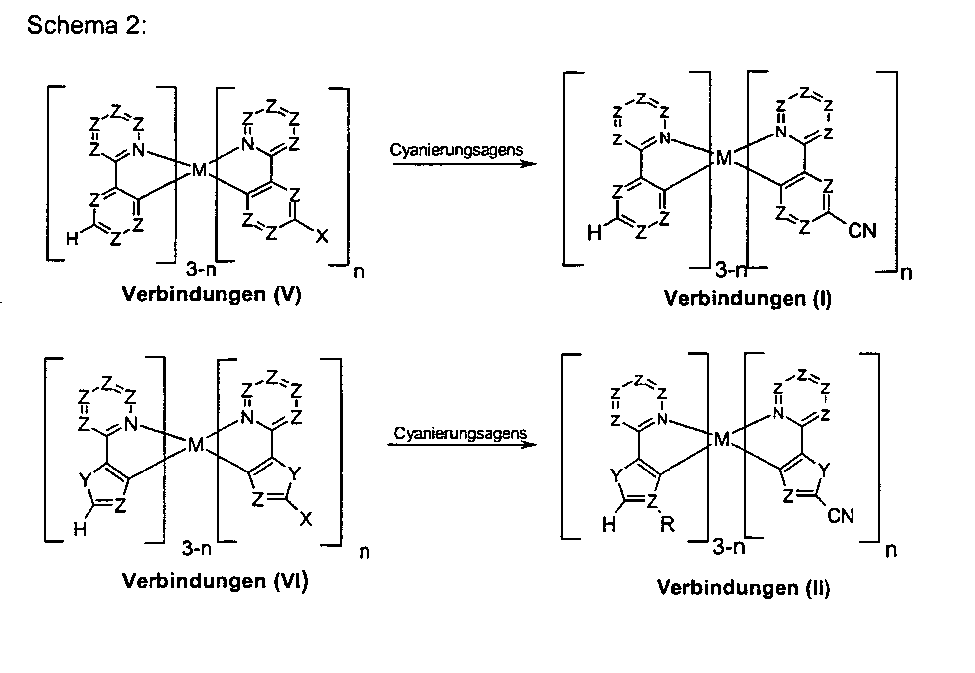

Ein weiterer Gegenstand der vorliegenden Erfindung, ist ein Verfahren zur Herstellung der Verbindungen (III) bzw. (IV), durch Umsetzung der Verbindungen (VII) bzw. (VIII) mit einem Cyanierungreagens, wie in Schema 3 erläutert.

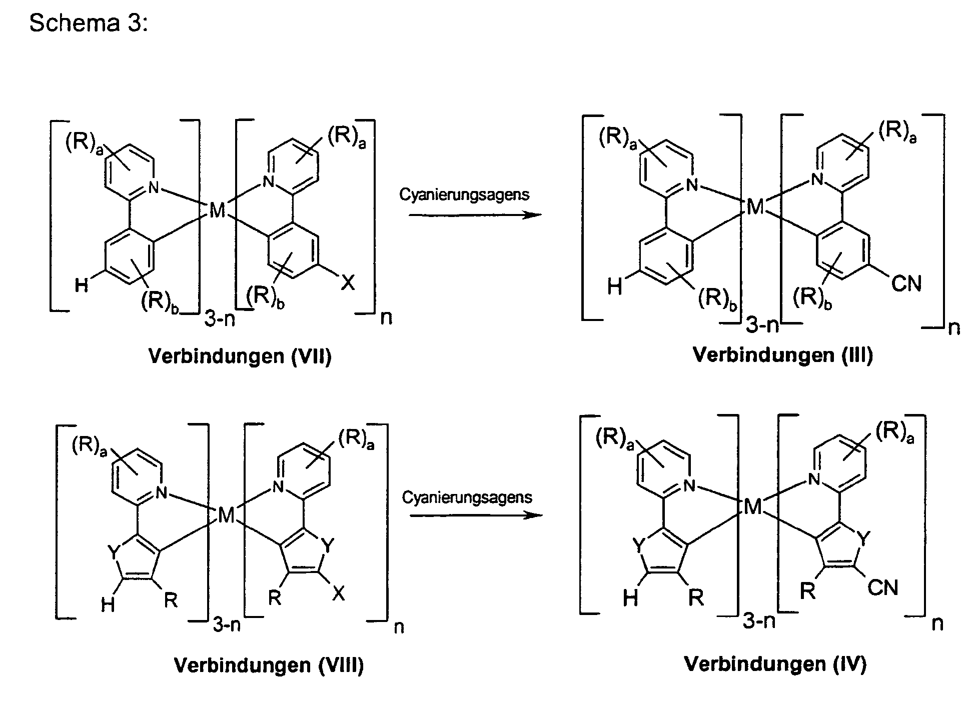

Erfindungsgemäße Cyanid-Quellen sind Verbindungen, die das Cyanidion in ionischer oder koordinativ gebundener Form enthalten, so z.B. Natrium-, Kalium-, Magnesium-, Tetraethylammonium-, Tetrabutylammonium-, Nickel(II)-, Kupfer(I)-, Silber(I)-, Zink(II)cyanid oder Natrium- und Kaliumdicyanocuprat(I), -tetracyanocuprat(II), -tetracyanozinkat(II), -tetracyanonickelat(II), -tetracyanopalladat(II)

Bevorzugte Cyanierungsagentien sind zum einen Übergangsmetallcyanide so z.B. Kupfer(I)cyanid oder Nickel(II)cyanid. Diese Cyanierungsagentien werden nachfolgend Cyanierungsagentien (1) genannt.

Ein weiteres bevorzugtes Cyanierungsagens ist Zink(II)cyanid in Gegenwart von Zink, und in Gegenwart von Nickel oder Palladium bzw. einer Nickel- oder Palladiumverbindung sowie gegebenenfalls eines Phosphor-haltigen Additivs. Diese Cyanierungsagentien werden nachfolgend Cyanierungsagentien (2) genannt.

Erfindungsgemäßes Nickel bzw. Nickelverbindungen für die Cyanierungsagentien (2) sind z.B. elementares Nickel, Nickelschwamm, Nickel auf Kieselgur, Nickel auf Aluminiumoxid, Nickel auf Silica, Nickel auf Kohle, Nickel(II)acetat, Nickel(II)acetylacetonat, Nickel(II)chorid, -bromid, -iodid, Additionsverbindungen des Typs NiL₂X₂ wobei X Chlor, Brom, lod und L einem neutralen Liganden wie z. B. Ammoniak, Acetonitril, Propionitril, Benzonitril, entspricht, Nickei(II)nitrat, Nickel(II)sulfat, Nickel(II)oxalat, Bis-cyclooctadiennickel(0).

Erfindungsgemäßes Palladium bzw. Palladiumverbindungen für die Cyanierungsagentien (2) sind z.B. elementares Palladium, Palladiumschwamm, Palladiumschwarz, Palladium auf Aktivkohle, Palladium auf Aluminiumoxid, Palladium auf Silica, Palladium auf Alkali- bzw. Erdalkalicarbonaten wie Natrium-, Kalium-, Calcium-, Strontium- oder Bariumcarbonat, Palladium auf Strontium- oder Bariumsulfat, bzw. Palladiumverbindungen wie z.B. Palladium(II)acetat, Palladium(II)trifluoroacetat, Palladium(II)propionat, Palladium(II)acetylacetonat, Palladium(II)chorid, -bromid, iodid, Additionsverbindungen des Typs PdL₂X₂ wobei X Chlor, Brom, lod und L einem neutralen Liganden wie z. B. Ammoniak, Acetonitril, Propionitril, Benzonitril, Cyclooctadien entspricht, Palladium(II)nitrat, Palladium(II)sulfat, Palladium(II)tetramin acetat, Palladium(II)tetrakis(acetonitril)-tetrafluoroborat, Natrium - und Kaliumtetracyanopalladat, Tetrakis(triphenylphosphino)palladium(0) und Tris-(dibenzylidenaceton)-dipalladium(0).

Erfindungsgemäß wird bei den Cyanierungsagentien (2) als Phosphor-haltiges Additiv ein Phosphin verwendet wird.
Erfindungsgemäße Phosphin-Liganden für die Cyanierungsagentien (2) sind aus der Gruppe der Tri-Aryl-Phosphine, Di-Aryl-Alkyl-Phosphine, Aryl-Dialkyl-Phosphine, Trialkyl-Phosphine, Tri-Hetaryl-Phosphine, Di-Hetaryl-Alkyl-Phosphine, Hetaryl-Dialkyl-Phosphine, wobei die Substituenten am Phosphor gleich oder verschieden, chiral oder achiral sein können wobei ein oder mehrere der Substituenten die Phosphorgruppen mehrerer Phosphine verknüpfen können und wobei ein Teil dieser Verknüpfungen auch ein oder mehrere Metallatome sein können, so z.B.

Triphenylphosphin, Tri-*o*-tolylphosphin, Tri-mesitylphosphin, Tri-*o*-anisylphosphin, Tri-(2,4,6-trismethoxyphenyl)phosphin, *Tert*-butyl-di-*o*-tolylphosphin, Di-*tert*-butyl-*o-*tolylphosphin, Dicyclohexyl-2-biphenylphosphin, Di-*tert*-butyl-2-biphenylphosphin, Triethylphosphin, Tri-*iso*-propyl-phosphin, Tri-cyclohexylphosphin, Tri-*tert-*butylphosphin, Tri-*tert*-pentylphosphin, Bis(di-*tert*-butylphosphino)methan, 1,1'-Bis(di-*tert*-butylphosphino)ferrocen.

Das erfindungsgemäße molare Verhältnis der Cyanierungsagentien (1) und (2) zu den Verbindungen (III) bzw. (IV) beträgt 1 n : 1 bis 10 n : 1, bevorzugt 1.5 n : 1 bis 3 n : 1.

Das erfindungsgemäße molare Verhältnis von Zink(II)cyanid zu Zink in den Cyanierungsagentien (2) beträgt 1 : 0.1 bis 1 : 0.001, bevorzugt 1 : 0.05 bis 1 : 0.005.

Das erfindungsgemäße molare Verhältnis von Nickel, einer Nickelverbindung, Palladium oder einer Palladiumverbindung zu den Verbindungen (III) bzw. (IV) beträgt 0.1 n : 1 bis 0.00001 n : 1.

Das erfindungsgemäße molare Verhältnis des Phosphor-haltigen Additivs zu Nickel, einer Nickelverbindung, Palladium oder einer Palladiumverbindung beträgt 0.5 : 1 bis 1000 : 1.

Erfindungsgemäße Reaktionsmedien sind dipolar aprotische Lösemittel so z.B. Nitrile wie Acetonitril, Propionitril oder Benzonitril oder N,N-Dialkylamide wie Dimethylformamid, Dimethylacetamid oder N-Methylpyrrolidinon, Sulfoxide wie Dimethylsulfoxid, Sulfone wie Dimethylsulfon oder Sulfolan.

Erfindungsgemäß wird die Umsetzung im Temperaturbereich von 60°C bis 200°C, bevorzugt bei 80°C bis 170°C, besonders bevorzugt bei 100°C bis 160°C durchgeführt.

Erfindungsgemäß liegt die Konzentration der Rhodium-haltigen bzw. Iridium-haltigen Edukte - Verbindungen (III), (IV), (V) bzw. Verbindungen (VI) - im Bereich von 0.0005 mol/I bis 2 mol/I, besonders bevorzugt im Bereich von 0.002 mol/l bis 0.1 mol/I.

Erfindungsgemäß können die Rhodium-haltigen bzw. Iridium-haltigen Edukte gelöst oder suspendiert im Reaktionsmedium vorliegen.

Erfindungsgemäß wird die Reaktion innerhalb von 1 Stunde bis zu 100 Stunden durchgeführt, bevorzugt innerhalb von 1 h bis 60 h.

Erfindungsgemäß kann die Reaktion unter Zusatz von inerten Mahlkörpern wie z. B. Keramik-, Glas- oder Metallkugeln oder Pall- oder Raschig-Ringen durchgeführt werden.

Mit den hier erläuterten Synthesemethoden lassen sich unter anderem die im folgenden dargestellten Beispiele für Verbindungen (I), (II), (III) bzw. (IV) herstellen.

| | | | | |
|---|---|---|---|---|
| 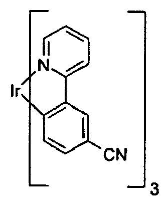 | 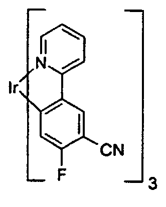 | 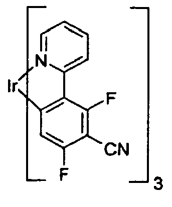 | 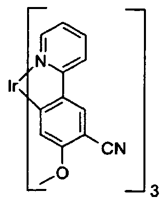 | 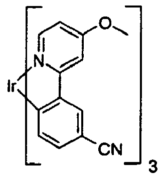 |
| Beispiel 1 | Beispiel 2 | Beispiel 3 | Beispiel 4 | Beispiel 7 |
| 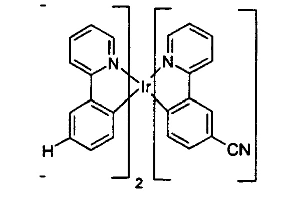 | | 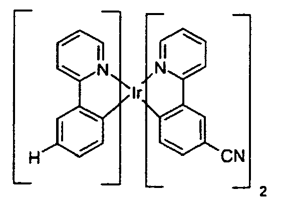 | | 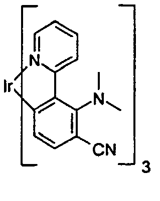 |
| Beispiel 5 | | Beispiel 6 | | Beispiel 8 |
| 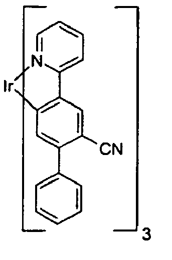 | 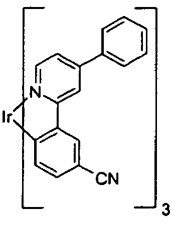 | 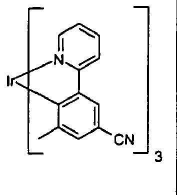 | 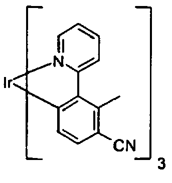 | 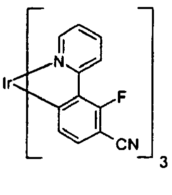 |
| Beispiel 9 | Beispiel 10 | Beispiel 11 | Beispiel 12 | Beispiel 13 |
| 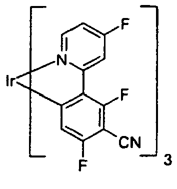 | 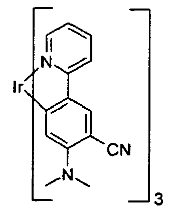 | 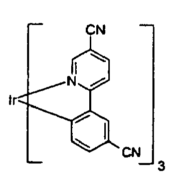 | 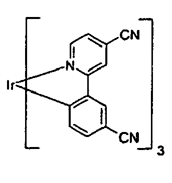 | 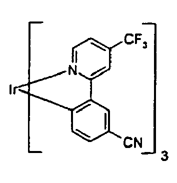 |
| Beispiel 14 | Beispiel 15 | Beispiel 16 | Beispiel 17 | Beispiel 18 |
| 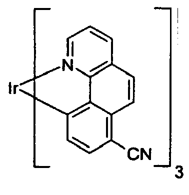 | 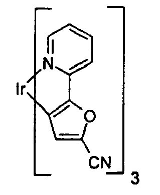 | 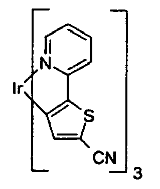 | 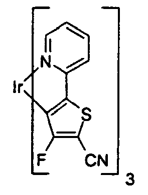 | 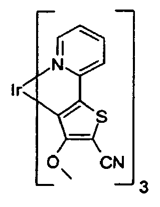 |
| Beispiel 19 | Beispiel 20 | Beispiel 21 | Beispiel 22 | Beispiel 23 |
| 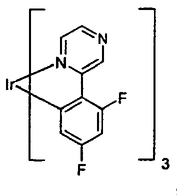 | 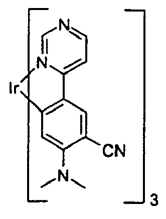 | 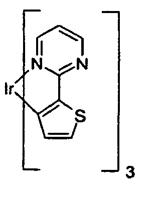 | 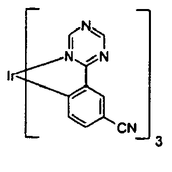 | 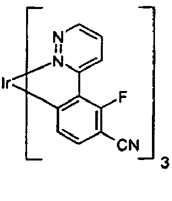 |
| Beispiel 24 | Beispiel 25 | Beispiel 26 | Beispiel 27 | Beispiel 28 |
| 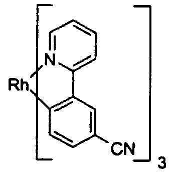 | 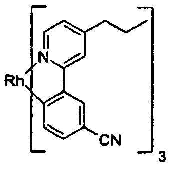 | 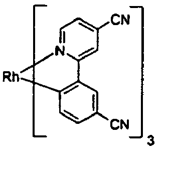 | 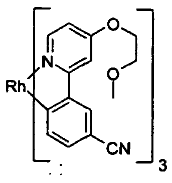 | 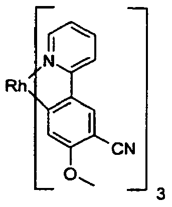 |
| Beispiel 29 | Beispiel 30 | Beispiel 31 | Beispiel 32 | Beispiel 33 |

Die erfindungsgemäßen Iridium- und Rhodiumverbindungen können in elektronischen Bauteilen, wie organische Leuchtdioden (OLEDs), organischen integrierten Schaltungen (O-ICs), organischen Feld-Effekt-Transistoren (OFETs), organischen Dünnfilmtransistoren (OTFTs), organischen Solarzellen (O-SCs), organischen Laserdioden (O-Laser), organischen Farbfilter für Liquid-Crystal-Displays oder organischen Photorezeptoren, Verwendung finden. Diese sind ebenfalls Bestandteil der vorliegenden Erfindung.

Die vorliegende Erfindung wird durch die folgenden Beispiele näher erläutert, ohne sie darauf beschränken zu wollen. Der Fachmann kann aus den Schilderungen ohne erfinderisches Zutun weitere erfindungsgemäße Komplexe herstellen bzw. das erfindungsgemäße Verfahren anwenden.

### 1. Synthese von symmetrisch und asymmetrisch funktionalisierten tris-orthometallierten Organo-Rhodium- bzw. Organo-Iridium-Verbindungen:

Die nachfolgenden Synthesen wurden - sofern nicht anders angegeben - an unter einer Schutzgasatmosphäre in getrockneten Lösungsmittel durchgeführt. Die Edukte wurden von ALDRICH [Natriumcyanid, Kupfer(I)cyanid, Zink(II)cyanid, Zink, Tetrakis-(triphenylphosphino)palladium(0), N-Methylpyrrolidinon (NMP)] bezogen. *fac*-Tris[2-(2-pyridinyl-κN)(5-bromphenyl)-κC]-iridium(III), fac-Tris[2-(2-pyridinyl-κN)((4-fluor)-5-(brom)phenyl)-κC]-iridium(III), *fac*-Tris[2-(2-pyridinyl-κN)((4,6-fluor)-5-(brom)phenyl)-κC]-iridium(III) und *fac*-Tris[2-(2-pyridinyl-κN)((4-methoxy)-5-(brom)phenyl)-κC]-iridium(III) wurde, wie in der nicht offengelegten Anmeldung DE 10109027.7 beschrieben, dargestellt.

Die Zuordnung der ¹H-NMR-Signale wurde zum Teil durch H-H-COSY-Spektren, die der 13C{¹H}-NMR-Signale jeweils über DEPT-135-Spektren abgesichert. Numerierungsschema für die Zuordnung der ¹H-NMR-Signale [nach: C. Coudret, S. Fraysse, J.-P- Launay, Chem. Commun., **1998**, 663-664]:

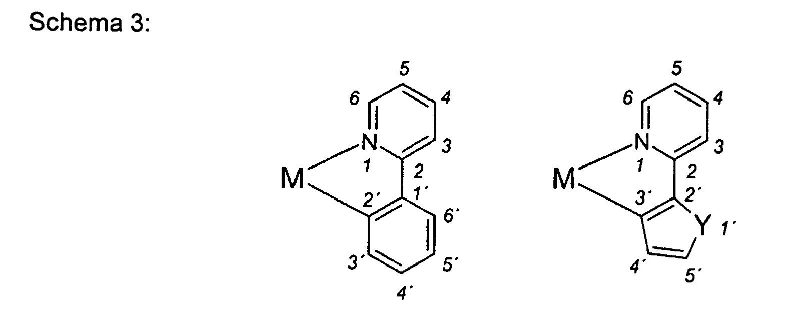

### Beispiel 1 : fac-Tris[2-(2-pyridinyl-κN)(5-cyanophenyl)-κC]-iridium(III)

### Methode A: Verwendung eines Cyanierungsagens 1

Eine Suspension von 8.915 g (10 mmol) *fac*-Tris[2-(2-pyridinyl-κN)(5-bromphenyl)-κC]-iridium(III) und 5.374 g (60 mmol) Kupfer(I)cyanid in 150 ml NMP wurde 60 h auf 145°C erhitzt. Nach Erkalten wurde die braune Lösung auf einmal in eine gut gerührte, 50°C warme Lösung von 7.4 g Natriumcyanid in einem Gemisch aus 500 ml Wasser und 500 ml Ethanol eingegossen und 2 h bei 50°C gerührt. Anschließend wurde der mikrokristalline Niederschlag abfiltriert (P4). Der mikrokristalline gelbe Niederschlag wurde dreimal mit je 100 ml einer Lösung von 7.4 g Natriumcyanid in einem Gemisch aus 500 ml Wasser und 500 ml Ethanol, dreimal mit je 100 ml eines Gemischs aus Ethanol und Wasser (1:1, v v) und abschließend zweimal mit 100 ml Ethanol gewaschen und dann im Vakuum (60°C, 10⁻⁴ mbar) getrocknet. Die Ausbeute - bei einer Reinheit von > 99.0 % nach ¹H-NMR - betrug 7.094 - 7.236 g entsprechend 97.2 - 99.1 %.

### Methode B: Verwendung eines Cyanierungsagens 2

Eine Suspension von 8.915 g (10 mmol) *fac*-Tris[2-(2-pyridinyl-κN)(5-bromphenyl)-κC]-iridium(III), 4.403 g (37.5 mmol) Zink(II)cyanid und 98 mg (1.5 mmol) Zinkstaub in 150 ml NMP wurde mit 347 mg (0.3 mmol) versetzt und 60 h auf 100°C erhitzt. Aufarbeitung analog Methode A. Die Ausbeute - bei einer Reinheit von > 99.0 % nach ¹H-NMR - betrug 6.877 - 6.956 g entsprechend 94.2 - 95.3 %.
¹HNMR (DMSO-d6): [ppm] = 8.41 (d, 1 H, ³J_{HH} = 8.4 Hz, H6), 8.31 (s, 1 H, H6'), 7.94 (br. dd, 1 H, ³J_{HH} = 8.4 Hz, ³J_{HH} = 6.8 Hz, H5), 7.54 (d, 1H, ³J_{HH} = 5.4 Hz, H3), 7.30 (br. dd, 1 H, ³J_{HH} = 6.8 Hz, ³J_{HH} = 5.4 Hz, H4), 7.11 (d, 1 H, ³J_{HH} = 8.0 Hz, H4'), 6.74 (d, 1 H, ³J_{HN} = 8.0 Hz, H3').
¹³C{¹H}NMR (DMSO-d6): [ppm] = 168.5 (q), 163.0 (q), 147.3 (t), 145.6 (q), 138.3 (t), 136.7 (t), 131.7 (t), 127.3 (t), 124.6 (t), 120.5 (t), 120.4 (q), 102.8 (q).

### Beispiel 2: fac-Tris[2-(2-pyridinyl-κN)(4-fluor-5-cyanophenyl)-κC]-iridium(III)

### Methode A: Verwendung eines Cyanierungsagens 1

Eine Suspension von 9.455 g (10 mmol) *fac*-Tris[2-(2-pyridinyl-κN)(4-fluor-5-bromphenyl)-κC]-iridium(III) und 5.374 g (60 mmol) Kupfer(I)cyanid in 200 ml NMP wurde 60 h auf 160°C erhitzt.
Aufarbeitung siehe Beispiel 1, Methode A. Die Ausbeute - bei einer Reinheit von > 99.0 % nach ¹H-NMR - betrug 7.638 - 7.710 g entsprechend 97.5- 98.4 %.
¹HNMR (DMSO-d6): [ppm] = 8.46 (d, 1 H, ⁴J_{HF} = 6.4 Hz, H6'), 8.40 (br. d, 1 H, ³J_{HH} = 8.3 Hz, H6), 8,01 (br. dd, 1 H, ³J_{HH} = 8.3 Hz, ³J_{HH} = 7.5 Hz, H5), 7.48 (br. d, 1 H, ³J_{HH} = 5.6 Hz, H3), 7.33 (br. dd, 1 H, ³J_{HH} = 7.5 Hz,³J_{HH} = 5.6 Hz, H4), 6.37 (d, 1 H, ³J_{HF} = 10.05 Hz, H3').

### Beispiel 3: fac-Tris[2-(2-pyridinyl-κN)(4,6-difluor-5-cyanophenyl)-κC]-iridium(III)

### Methode A: Verwendung eines Cyanierungsagens 1

Eine Suspension von 9.635 g (10 mmol) *fac*-Tris[2-(2-pyridinyl-κN)(4,6-fluor-5-bromphenyl)-κC]-iridium(III) und 5.374 g (60 mmol) Kupfer(I)cyanid in 200 ml NMP wurde 60 h auf 160°C erhitzt.
Aufarbeitung siehe Beispiel 1, Methode A. Die Ausbeute - bei einer Reinheit von > 99.0 % nach ¹H-NMR - betrug 7.638 - 7.710 g entsprechend 97.5- 98.4 %.
¹HNMR (DMSO-d6): [ppm] = 8.46 (br. d, 1 H, ³J_{HH} = 8.2 Hz, H6), 8,21 (br. dd, 1 H, ³J_{HH} = 8.2 Hz, ³J_{HH} = 7.0 Hz, H5), 7.47 (br. d, 1 H, ³J_{HH} = 5.8 Hz, H3), 7.30 (br. dd, 1 H, ³J_{HH} = 7.0 Hz, ³J_{HH} = 5.8 Hz, H4), 6.32 (dd, 1 H, ³J_{HF} = 10.05 Hz, ⁵J_{HF} = 1.35 Hz H3').

### Beispiel 4: fac-Tris[2-(2-pyridinyl-κN)(4-methoxy-5-cyanophenyl)-κC]-iridium(III)

### Methode A: Verwendung eines Cyanierungsagens 1

Eine Suspension von 9.816 g (10 mmol) *fac*-Tris[2-(2-pyridinyl-κN)(4-methoxy-5-bromphenyl)-κC]-iridium(III) und 5.374 g (60 mmol) Kupfer(I)cyanid in 200 ml NMP wurde 60 h auf 145°C erhitzt.
Aufarbeitung siehe Beispiel 1, Methode A. Die Ausbeute - bei einer Reinheit von > 99.0 % nach ¹H-NMR - betrug 7.935 - 8.030 g entsprechend 96.7 - 97.9 %.
¹HNMR (DMSO-d6): [ppm] = 8.27 (d, 1 H, ³J_{HH} = 8.4 Hz, H6), 8.21 (s, 1 H, H6'), 7.94 (br. dd, 1 H, ³J_{HH} = 8.4 Hz, ³J_{HH} = 6.7 Hz, H5), 7.54 (d, 1 H, ³J_{HH} = 5.1 Hz, H3), 7.30 (br. dd, 1 H, ³J_{HH} = 6.7 Hz, ³J_{HH} = 5.1 Hz, H4), 6.41 (s, 1 H, H3'), 3.48 (s, 3 H, CH₃).

### 2. Herstellung und Charakterisierung von Organischen Elektroluminszenz-Vorrichtungen, die erfindungsgemäße Verbindungen enthalten.

Die Herstellung von LEDs erfolgte nach dem im folgenden skizzierten allgemeinen Verfahren. Dieses mußte natürlich im Einzelfall auf die jeweiligen Gegebenheiten (z. B. Schichtdickenvariation um optimale Effizienz bzw. Farbe zu erreichen) angepaßt werden.

Allgemeines Verfahren zur Herstellung von OLEDs:
Nachdem man die ITO-beschichteten Substrate (z. B. Glasträger, PET-Folie) auf die richtige Größe zugeschnitten hat, werden sie in mehreren Reinigungsschritten im Ultraschallbad gereinigt (z.B. Seifenlösung, Millipore-Wasser, Isopropanol).
Zur Trocknung werden sie mit einer N₂-Pistole abgepustet und in einem Exsikkator gelagert. Vor der Bedampfung mit den organischen Schichten werden sie mit einem Ozon-Plasma-Gerät für ca. 20 Minuten behandelt. Es kann sich empfehlen, als erste organische Schicht eine polymere Lochinjektionsschicht zu verwenden. Dies ist in der Regel ein konjugiertes, leitfähiges Polymer, wie z. B. ein Polyanilinderivat (PANI) oder eine Polythiophenderivat (z. B. PEDOT, BAYTRON P^{™} von BAYER). Diese wird dann durch Spin-Coaten (Lackschleudern) aufgebracht.

Die organischen Schichten werden der Reihe nach durch Aufdampfen in einer Hochvakuum-Anlage aufgebracht. Dabei wird die Schichtdicke der jeweiligen Schicht und die Bedampfungsrate über einen Schwingquarz verfolgt bzw. eingestellt. Es können auch - wie oben beschrieben - einzelne Schichten aus mehr als einer Verbindung bestehen, d. h. in der Regel ein Wirtsmaterial (host) mit einem Gastmaterial (guest) dotiert sein. Dies wird durch Co-Verdampfung aus zwei bzw. mehreren Quellen erzielt.
Auf die organischen Schichten werden noch Elektroden aufgebracht. Dies geschieht in der Regel durch thermisches Verdampfen (Balzer BA360 bzw. Pfeiffer PL S 500). Anschließend wird die durchsichtige ITO-Elektrode als Anode und die Metallelektrode (z. B. Ca, Yb, Ba-Al) als Kathode kontaktiert und die Device-Parameter bestimmt.

### Beispiel 5:

Analog dem o. g. allgemeinen Verfahren, wurde eine blau emittierende OLED mit folgendem Aufbau erzeugt:
- PEDOT: 20 nm (aus Wasser aufgeschleudert; PEDOT bezogen von BAYER AG; Poly-[3,4-ethylendioxy-2,5-thiophen]
- MTDATA: 20 nm (aufgedampft; MTDATA bezogen von SynTec; Tris-4,4',4"-(3-methylphenyl-phenylamino)triphenylamin)
- S-TAD: 20 nm (aufgedampft; S-TAD hergestellt nach WO99/12888; 2,2',7,7'-Tetrakis(diphenylamino)-spirobifluoren)
- CPB: 20 nm (aufgedampft; CPB bezogen von ALDRICH und weiter aufgereinigt, schließlich noch zweimal sublimiert; 4,4'-Bis-(N-carbazolyl)biphenyl) dotiert mit 6%
- Triplett-Emitter: *fac-Tris[2-(2-pyridinyl-κN)(4-fluor-5-cyanophenyl)-κC]-iridium(III) vergleiche Beispiel 3*
- BCP: 8 nm (aufgedampft; BCP bezogen von ABCR, verwendet wie erhalten; 2,9-Dimethyl-4,7-diphenyl-1,10-phenanthrolin)
- AlQ₃: 20 nm (aufgedampft: AlQ₃ bezogen von SynTec; Tris(chinoxalinato)aluminim(III)
- *Yb*: *150 nm als Kathode*

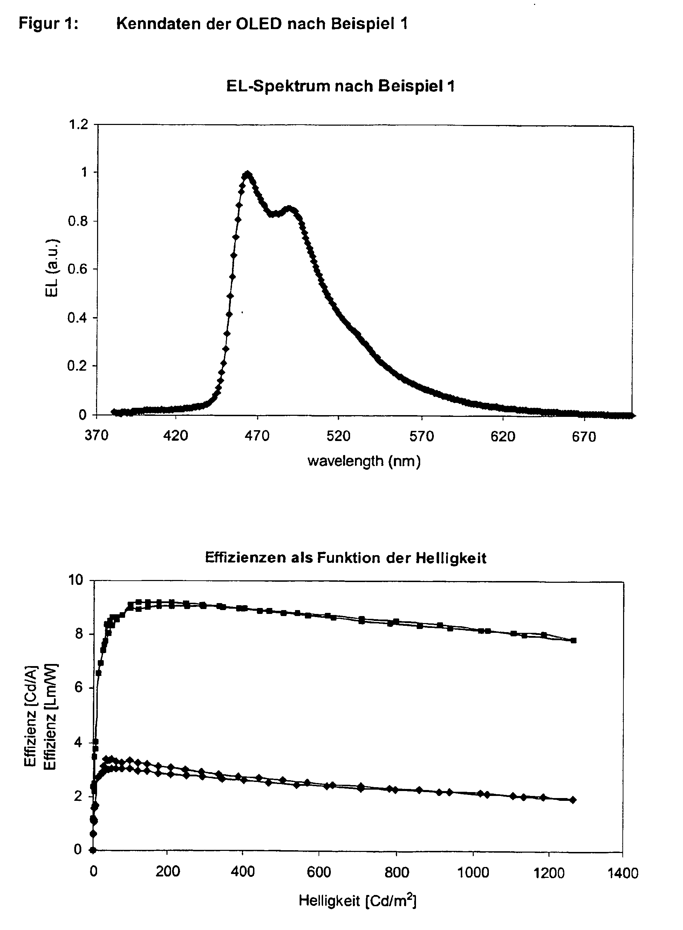

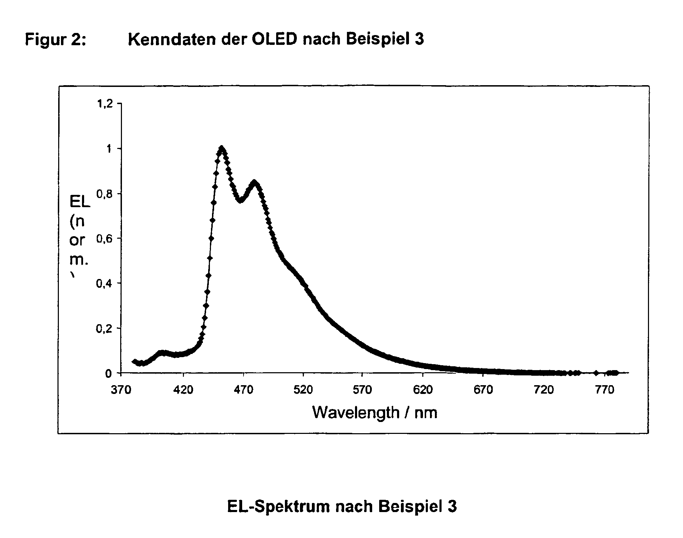

Diese nicht optimierten OLEDs wurden standardmäßig charakterisiert; das EL-Spektrum ist in Figur 1 wiedergegeben. Neben der Farbe ist ein enormer Vorteil dieser OLED ist die Flachheit der Effizienzkurve, was bedeutet, dass auch bei sehr hohen Helligkeiten (z. B. 10000 Cd/m²) immer noch sehr hohe Effizienzen erzielt werden. Dies ist v. a. für die Verwendung in Passiv-Matrix-getriebenen Displays von entscheidender Bedeutung.

## Patentansprüche

1. Verbindungen der Formel (I) und (II), 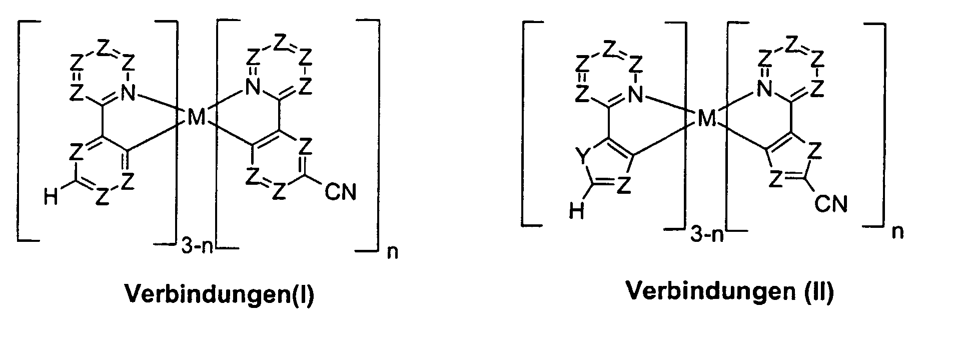 wobei die Symbole und Indizes folgende Bedeutung haben:
M Rh, Ir;
Z ist gleich oder verschieden bei jedem Auftreten N, CR ;
Y O, S, Se;
R ist gleich oder verschieden bei jedem Auftreten H, F, Cl, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR² - ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
R¹,R² sind gleich oder verschieden, H oder ein aliphatischer oder aromatischer Kohlenwasserstoffrest mit 1 bis 20 C-Atomen;
n ist 1, 2 oder 3

2. Verbindungen der Formel (la) und (IIa) 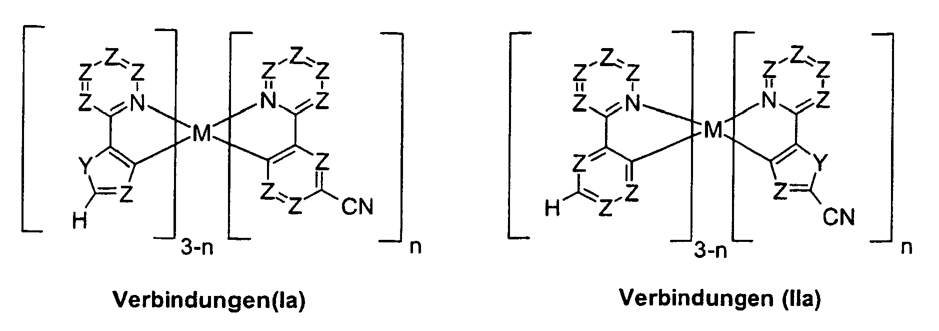 wobei die Symbole und Indizes die Bedeutungen wie in Anspruch 1 haben.

3. Verbindungen der Formel (III) und (IV), 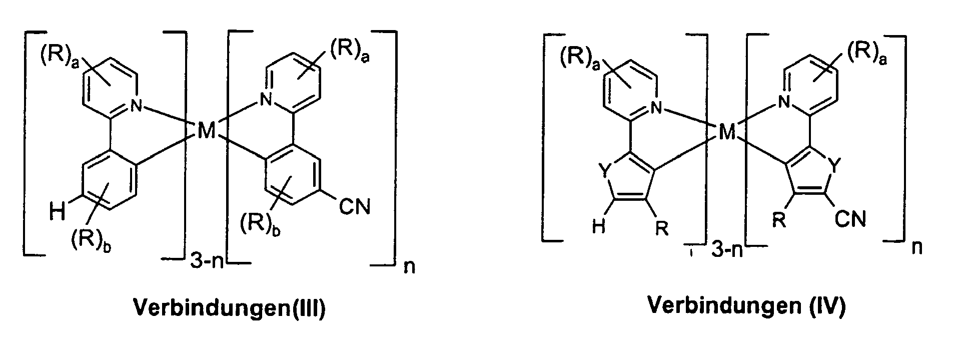 wobei die Symbole M, Y, R, R¹, R² und Indizes n die Bedeutungen wie in Anspruch 1 haben und
a ist 0, 1, 2, 3 oder 4, bevorzugt 0, 1 oder 2, besonders bevorzugt 0 oder 1;
b ist 0, 1, 2 oder 3, bevorzugt 0 oder 1.

4. Verbindungen der Formel (IIIa) und (IVa) 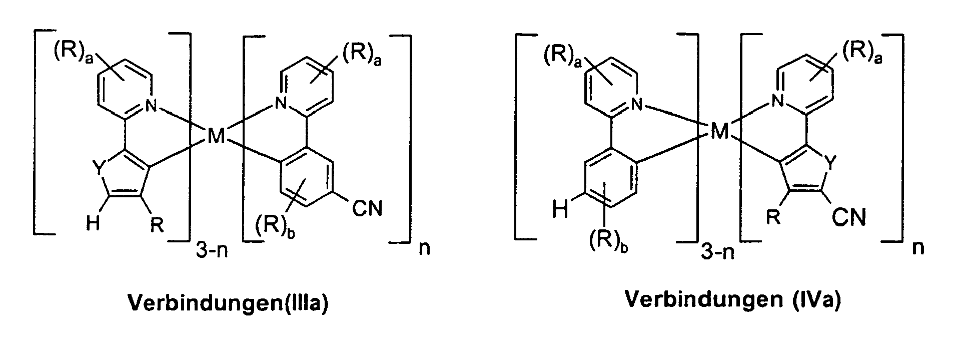 wobei die Symbole und Indizes die Bedeutungen wie in Anspruch 1 und 3 haben.

5. Verfahren zur Herstellung der Verbindungen gemäß Anspruch 1, durch Umsetzung der Verbindungen (V) bzw. (VI), 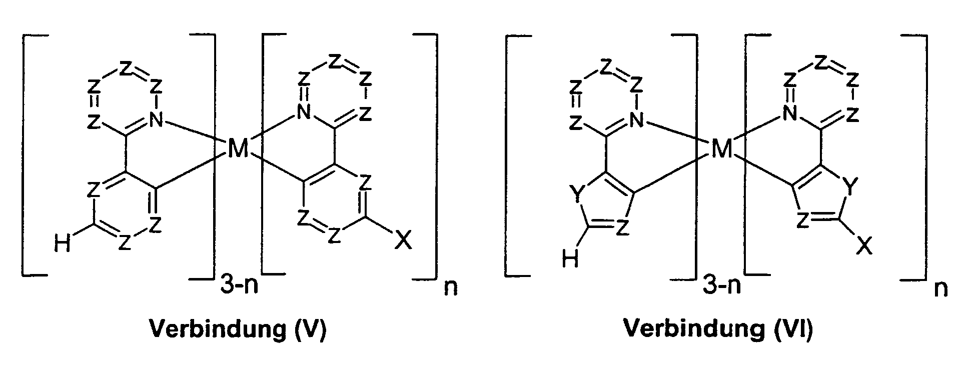 worin
X Cl, Br oder I ist und worin M und die Reste und Indizes Z, Y und R die in Anspruch 1 genannten Bedeutungen haben, mit Cyanierungsagentien.

6. Verfahren zur Herstellung der Verbindungen gemäß Anspruch 3, durch Umsetzung der Verbindungen (VII) bzw. (VIII), 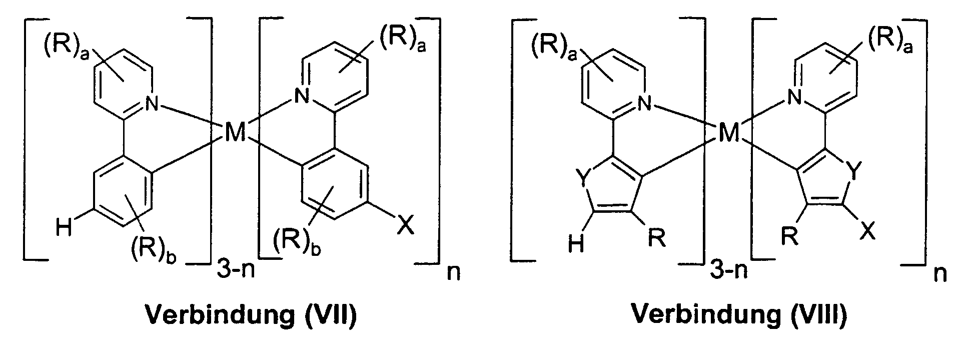 worin
X Cl, Br oder I ist und worin M und die Reste und Indizes Y, R, a, und b die in Ansprüchen 1 und 3 genannten Bedeutungen haben, mit Cyanierungsagentien.

7. Verfahren gemäß Anspruch 5 und /oder 6, **dadurch gekennzeichnet, dass** als Cyanierungsagentien Systeme mit Cyanid-Quellen, die das Cyanidion in ionischer oder koordinativ gebundener Form enthalten, verwendet werden.

8. Verfahren gemäß einem oder mehreren der Ansprüche 5 bis 7 **dadurch**, **dadurch gekennzeichnet, dass** als Cyanierungsagentien Kupfer(I)cyanid oder Nickel(II)cyanid verwendet werden.

9. Verfahren gemäß einem oder mehreren der Ansprüche 5 bis 8 **dadurch gekennzeichnet, dass** als Cyanierungsagens Zink(II)cyanid in Gegenwart von Zink und in Gegenwart von Nickel oder Palladium bzw. einer Nickel- oder Palladiumverbindung sowie gegebenenfalls eines Phosphor-haltigen Additivs verwendet wird.

10. Verfahren gemäß einem oder mehreren der Ansprüche 5 bis 9 **dadurch gekennzeichnet, dass** das molare Verhältnis der Cyanierungsagentien (1) und (2) zu den Verbindungen (V), (VI), (VII) bzw. (VIII) 1n : 1 bis 10 n : 1, bevorzugt 1.5 n : 1 bis 3 n : 1 beträgt.

11. Verfahren gemäß einem oder mehreren der Ansprüche 5, 6, 9 und 10 **dadurch gekennzeichnet, dass** molare Verhältnis von Zink(II)cyanid zu Zink in den Cyanierungsagentien (2) 1 : 0.1 bis 1 : 0.001, bevorzugt 1 : 0.05 bis 1 : 0.005 beträgt.

12. Verfahren gemäß einem oder mehreren der Ansprüche 5, 6 und 9 bis 11 **dadurch gekennzeichnet, dass** das Verhältnis von Nickel, einer Nickelverbindung, Palladium oder einer Palladiumverbindung zu den Verbindungen (V), (VI), (VII) bzw. (VIII) 0.1 n : 1 bis 0.00001 n : 1 beträgt.

13. Verfahren gemäß einem oder mehreren der Ansprüche 5, 6 und 9 bis 12 **dadurch gekennzeichnet, dass** das Verhältnis des Phosphor-haltigen Additivs zu Nickel, einer Nickelverbindung, Palladium oder einer Palladiumverbindung beträgt 0.5 : 1 bis 1000 : 1.

14. Elektronisches Bauteil enthaltend mindestens eine Verbindung gemäß einem oder mehreren der Ansprüche 1 bis 4.

15. Elektronisches Bauteil, gemäß Anspruch 14 **dadurch gekennzeichnet , dass** es sich um eine Organische Leuchtdioden (OLEDs), eine Organische Integrierte Schaltung (O-ICs), einen Organischen Feld-Effekt-Transistoren (OFETs), einen Organische Dünnfilmtransistoren (OTFTs), eine Organische Solarzellen (O-SCs) oder auch eine Organische Laserdioden (O-Laser) handelt.

## Claims

1. Compounds of the formula (I) and (II), 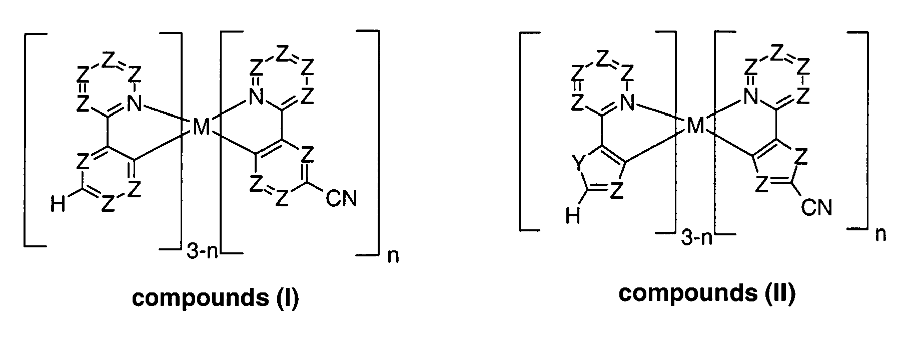 whereby the symbols and indices have the following meanings:
M Rh, Ir;
Z is identical or different with each occurrence of N, CR ;
Y O, S, Se;
R is identical or different with each occurrence of H, F, Cl, NO₂, CN, a straight-chain or branched or cyclical alkyl or alkoxy group with 1 to 20 C atoms, whereby one or more non-neighbouring CH₂ groups can be replaced by -O-, -S-, -NR¹-, or -CONR ²- and whereby one or more H atoms can be replaced by F, or an aryl or heteroaryl group with 4 to 14 C atoms, which can be substituted by one or more non-aromatic radicals R; whereby several substituents R, both on the same ring as well as on the two different rings together, can in turn set up a further mono- or poly-cyclical ring system;
R¹,R² are identical or different, H or an aliphatic or aromatic hydrocarbon radical with 1 to 20 C atoms;
n is 1, 2 or 3

2. Compounds of the formula (Ia) and (IIa) 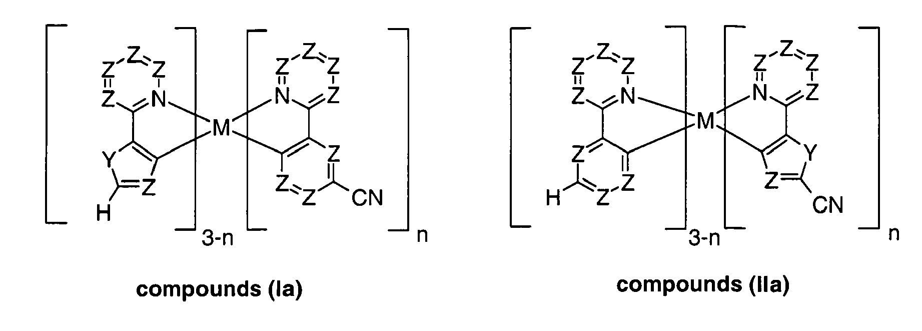 whereby the symbols and indices have the meanings as in claim 1.

3. Compounds of the formula (III) and (IV), 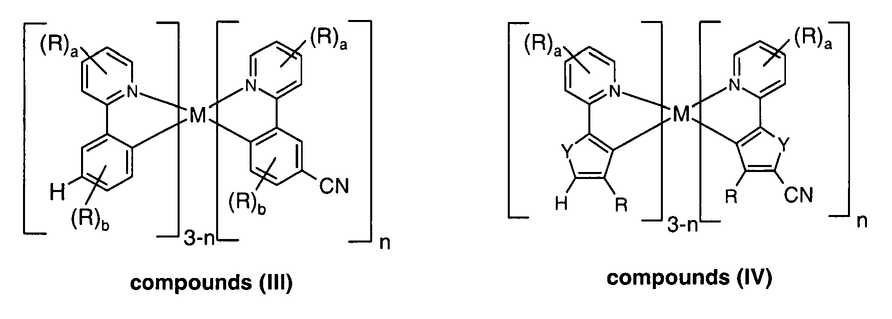 whereby the symbols M, Y, R, R¹, R² and indices n have the meanings as in claim 1 and
a is 0, 1, 2, 3 or 4, preferably 0, 1 or 2, particularly preferably 0 or 1;
b is 0, 1, 2 or 3, preferably 0 or 1.

4. Compounds of the formula (IIIa) and (IVa) 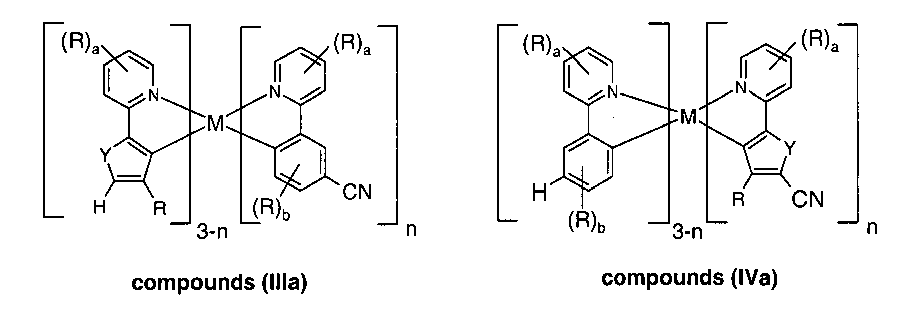 whereby the symbols and indices have the meanings as in claim 1 and 3.

5. The method for the production of the compounds according to claim 1, by conversion of the compounds (V) and (VI), 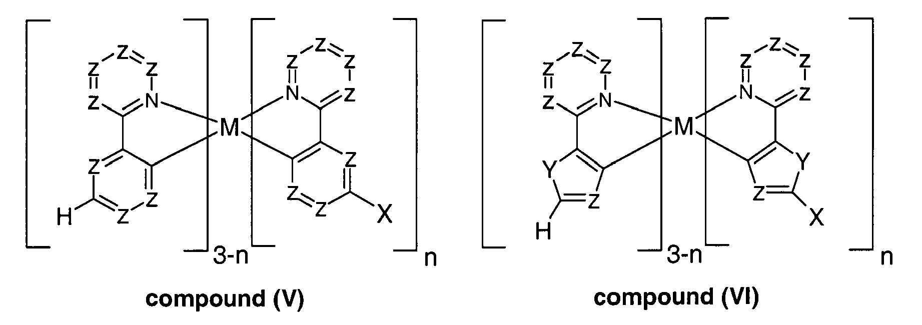 wherein
X is Cl, Br or I and wherein M and the radicals and indices Z, Y and
R have the meanings stated in claim 1, with cyanisation agents.

6. The method for the production of compounds according to claim 3, by conversion of the compounds (VII) and (VIII), 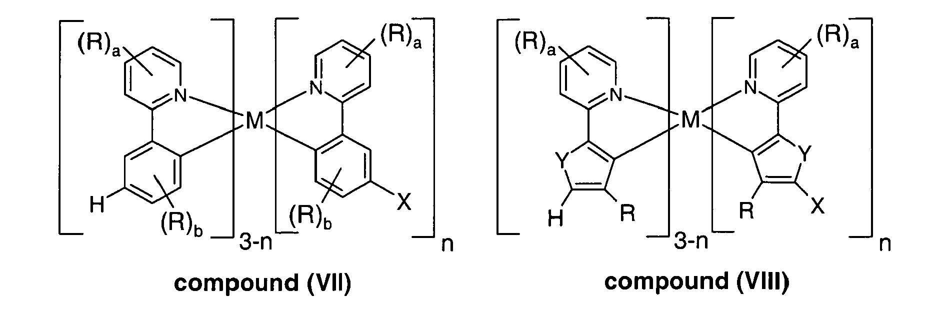 wherein
X is Cl, Br or I and wherein M and the radicals and indices Y, R, a, and b have the meanings stated in claims 1 and 3, with cyanisation agents.

7. The method according to claim 5 and/or 6, **characterised in that**, as cyanisation agents, use is made of systems with cyanide sources which contain the cyanide ion in ionic or coordinatively bound form.

8. The method according to one or more of claims 5 to 7, **characterised in that** copper(I)cyanide or nickel(II)cyanide are used as cyanisation agents.

9. The method according to one or more of claims 5 to 8, **characterised in that**, as the cyanisation agent, use is made of zinc(II)cyanide in the presence of zinc and in the presence of nickel or palladium or a nickel or palladium compound and optionally a phosphorus-containing additive.

10. The method according to one or more of claims 5 to 9, **characterised in that** the molar ratio of cyanisation agents (1) and (2) to compounds (V), (VI), (VII) and (VIII) amounts to 1 n : 1 to 10 n : 1, preferably 1.5 n : 1 to 3 n : 1.

11. The method according to one more of claims 5, 6, 9 and 10, **characterised in that** the molar ratio of zinc(II)cyanide zu zinc in cyanisation agents (2) amounts to 1 : 0.1 to 1 : 0.001, preferably 1 : 0.05 to 1 : 0.005.

12. The method according to one or more of claims 5, 6 and 9 to 11,**characterised in that** the ratio of nickel, a nickel compound, palladium or a palladium compound to compounds (V), (VI), (VII) and (VIII) amounts to 0.1 n : 1 to 0.00001 n : 1.

13. The method according to one or more of claims 5, 6 and 9 to 12, **characterised in that** the ratio of the phosphorus-containing additive to nickel, a nickel compound, palladium or a palladium compound amounts to 0.5 : 1 to 1000 : 1.

14. An electronic component containing at least one compound according to one or more of claims 1 to 4.

15. The electronic component according to claim 14, **characterised in that** it concerns organic light diodes (OLEDs), organic integrated circuits (O-ICs), organic field-effect transistors (OFETs), organic thin-film transistors (OTFTs), organic solar cells (O-SCs) or also organic laser diodes (O-Iasers).

## Revendications

1. Composés des formules (I) et (II) 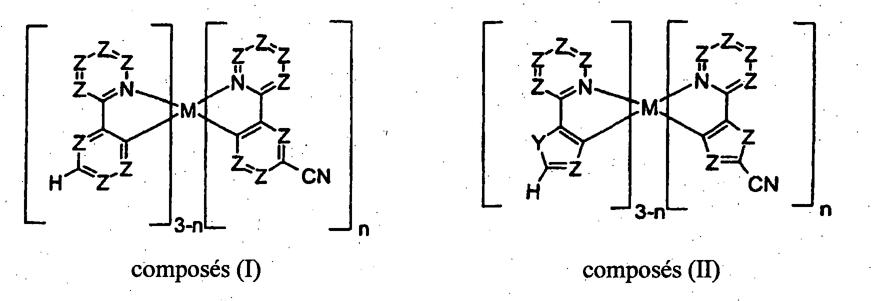 où les symboles et indices ont la signification suivante :
M est Rh, Ir ;
Z est, identique ou différent à chaque occurrence, N, CR ;
Y est O, S, Se ;
R est, identique ou différent à chaque occurrence, H, F, Cl, NO₂, CN, un groupe alkyle ou alcoxy linéaire ou ramifié ou cyclique ayant 1 à 20 atomes C, où un ou plusieurs groupes CH₂ non voisins peuvent être remplacés par -O-, -S-, -NR¹- ou -CONR²- et où un ou plusieurs atomes H peuvent être remplacés par F, ou un groupe aryle ou hétéroaryle ayant 4 à 14 atomes C, qui peut être substitué par un ou plusieurs groupements R non aromatiques ; où plusieurs substituants R, sur le même cycle ou sur les deux cycles différents peuvent former ensemble un autre système cyclique mono- ou polycyclique ;
R¹, R² sont, identiques ou différents, H ou un groupement hydrocarboné aliphatique ou aromatique ayant 1 à 20 atomes C ;
n est 1, 2 ou 3.

2. Composés des formules (Ia) et (IIa) 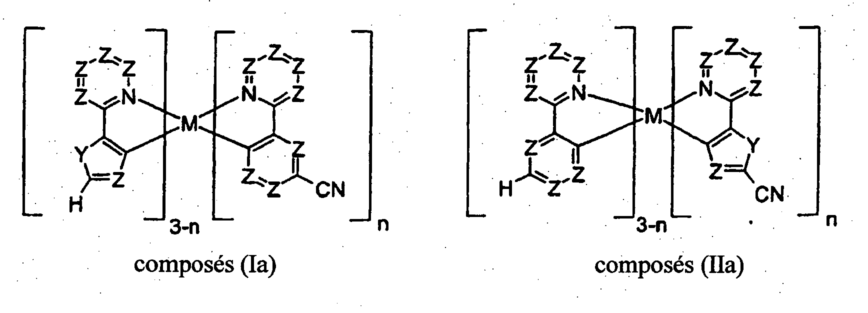 où les symboles et indices ont les mêmes significations que dans la revendication 1.

3. Composés des formules (III) et (IV) 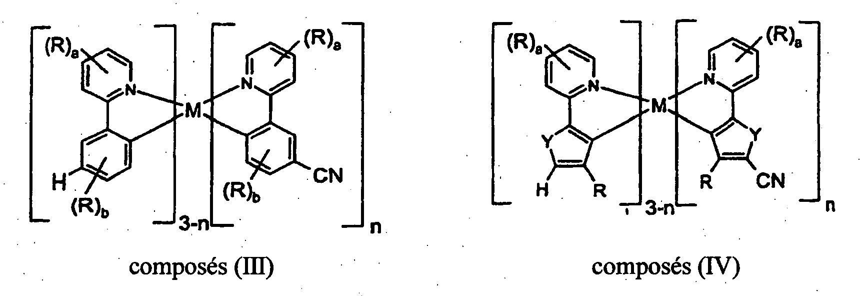 où les symboles M, Y, R, R¹, R² et indices n ont les mêmes significations que dans la revendication 1 et
a est 0, 1, 2, 3 ou 4, de préférence 0, 1 ou 2, de manière particulièrement préférée 0 ou 1 ;
b est 0, 1, 2 ou 3, de préférence 0 ou 1.

4. Composés des formules (IIIa) et (IVa) 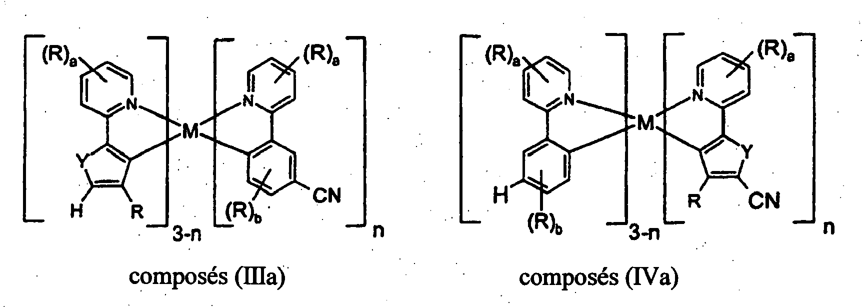 où les symboles et indices ont les mêmes significations que dans les revendications 1 et 3.

5. Procédé de préparation des composés selon la revendication 1 par réaction des composés (V) ou (VI) 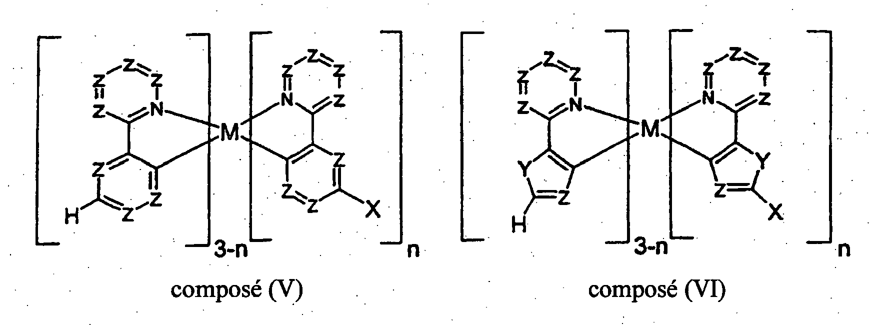 où
X est Cl, Br ou I et où M et les groupements et indices Z, Y et R ont les significations citées dans la revendication 1, avec des agents de cyanuration.

6. Procédé de préparation des composés selon la revendication 3 par réaction des composés (VII) ou (VIII) 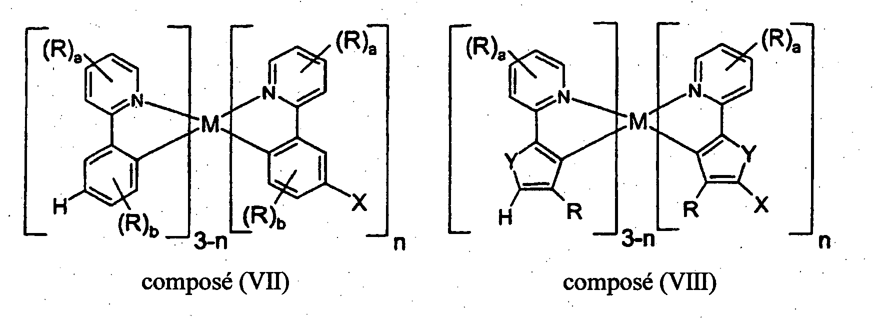 où
X est Cl, Br ou I et où M et les groupements et indices Y, R, a et b ont les significations citées dans les revendications 1 et 3, avec des agents de cyanuration.

7. Procédé selon la revendication 5 et/ou 6 **caractérisé en ce que** des systèmes avec des sources de cyanure qui contiennent l'ion cyanure sous forme ionique ou liée par coordination sont utilisés comme agents de cyanuration.

8. Procédé selon une ou plusieurs des revendications 5 à 7 **caractérisé en ce que** le cyanure de cuivre (I) ou le cyanure de nickel (I) est utilisé comme agent de cyanuration.

9. Procédé selon une ou plusieurs des revendications 5 à 8 **caractérisé en ce que** le cyanure de zinc (II) en présence de zinc et en présence de nickel ou de palladium ou d'un composé de nickel ou de palladium et éventuellement d'un additif contenant du phosphore est utilisé comme agent de cyanuration.

10. Procédé selon une ou plusieurs des revendications 5 à 9 **caractérisé en ce que** le rapport molaire des agents de cyanuration (1) et (2) aux composés (V), (VI), (VII) ou (VIII) est 1 n : 1 à 10 n : 1, de préférence 1,5 n : 1 à 3 n : 1.

11. Procédé selon une ou plusieurs des revendications 5, 6, 9 et 10 **caractérisé en ce que** le rapport molaire du cyanure de zinc (II) au zinc dans les agents de cyanuration (2) est 1 : 0,1 à 1 : 0,001, de préférence 1 : 0,05 à 1 : 0,005.

12. Procédé selon une ou plusieurs des revendications 5, 6 et 9 à 11 **caractérisé en ce que** le rapport du nickel, d'un composé du nickel, du palladium ou d'un composé du palladium aux composés (V), (VI), (VII) ou (VIII) est 0,1 n : 1 à 0,00001 n : 1.

13. Procédé selon une ou plusieurs des revendications 5, 6 et 9 à 12 **caractérisé en ce que** le rapport de l'additif contenant du phosphore au nickel, à un composé du nickel, au palladium ou à un composé du palladium est 0,5 : 1 à 1000 : 1.

14. Composant électronique contenant au moins un composé selon une ou plusieurs des revendications 1 à 4.

15. Composant électronique selon la revendication 14 **caractérisé en ce qu'**il s'agit d'une diode électroluminescente organique (OLED), d'un circuit intégré organique (O-IC), d'un transistor à effet de champ organique (OFET), d'un transistor à couche mince organique (OTFT), d'une cellule solaire organique (O-SC) ou encore d'une diode laser organique (O-laser).
